(19) Europäisches Patentamt / European Patent Office / Office européen des brevets

(11) EP 2 514 590 B1

(12) **EUROPÄISCHE PATENTSCHRIFT**

(45) Veröffentlichungstag und Bekanntmachung des Hinweises auf die Patenterteilung:
**18.06.2014 Patentblatt 2014/25**

(51) Int Cl.:
***B32B 15/08*** *(2006.01)* ***H05K 1/00*** *(2006.01)*
***B32B 27/06*** *(2006.01)*

(21) Anmeldenummer: **12161486.1**

(22) Anmeldetag: **27.03.2012**

(54) **Verfahren zur Herstellung eines kleberlosen Verbunds aus einer Polyaryleneetherketonfolie und einer Metallfolie**

Process for producing an adhesive-free composite made of a polyarylene ether ketone foil and a metal foil

Procédé de fabrication d'un composite sans colle composé d'une feuille de cétone de polyarylène éther et d'une feuille métallique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.04.2011 DE 102011007837**

(43) Veröffentlichungstag der Anmeldung:
**24.10.2012 Patentblatt 2012/43**

(73) Patentinhaber: **Evonik Degussa GmbH**
**45128 Essen (DE)**

(72) Erfinder:
- **Alting, Kirsten**
  **48153 Münster (DE)**
- **Blaschke, Jörg**
  **42857 Remscheid (DE)**

(56) Entgegenhaltungen:
**EP-A1- 1 234 857 EP-A1- 1 314 760**
**WO-A1-2011/048093**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 514 590 B1

## Beschreibung

Die Erfindung betrifft ein Verfahren zur Herstellung eines Verbunds, bei dem eine Folie aus einer Polyarylenetherketonformmasse einseitig oder beidseitig kleberlos mit einer Metallfolie verbunden ist. Die Verbindung der Folien wird durch Verpressen bei erhöhter Temperatur erzeugt. Die Metallfolie wird hierbei als solche aufgebracht und nicht, wie in alternativen Verfahren, durch Vakuumabscheidungsverfahren oder elektrolytisch. Der Verbund wird beispielsweise als flexible Leiterplatte (FCB) verwendet.

Die Herstellung und Verwendung von Folien aus Polyarylenetherketonen ist Stand der Technik. Die Folien werden für vielfältige technische Anwendungen eingesetzt, beispielsweise als Isolierstoff oder als Träger von funktionellen Schichten. Hierbei werden, je nach Anforderungen, Polyarylenetherketone mit verschiedenen Füllstoffen und gegebenenfalls weiteren Polymeren zu Compounds bzw. Blends gemischt und diese dann zu Folien weiterverarbeitet. Mittlerweile sind Foliendicken von weniger als 10 $\mu$m realisiert. Im Fokus der Eigenschaftsprofile stehen vor allem hohe Medien-und Temperaturbeständigkeit bei gleichzeitig geringem Schrumpf- und Ausdehnungsverhalten sowie ein Höchstmaß an Einreiß- und Weiterreißfestigkeit.

Je nach Extrusionsprozessführung sind Polyarylenetherketone sowohl zu amorphen als auch zu teilkristallinen Folien verarbeitbar. Um möglichst geringen und gleichmäßigen Schrumpf zu erzielen, muss die Folie maximal teilkristallin hergestellt sein und eine möglichst geringe Orientierung der Polymermoleküle aufweisen. Bei der Extrusion kommt die amorphe Schmelze des Polyarylenetherketons aus der Düse auf die sogenannten Chill-Roll-Walzen und muss dort prozesstechnisch aufwendig in sehr engen Prozessfenstern zu maximal teilkristallinen Folien umgewandelt werden. Prozesstechnisch ist es bei diesem Verfahren jedoch kaum möglich, die Orientierungen der Polymermoleküle in der Folie komplett isotrop einzustellen. Somit entsteht hinsichtlich der Schrumpfeigenschaften ein unterschiedliches Bild, welches sich über die Breite der Folienbahn hinweg mitunter stark schwankend ändert und sich bei der weiteren Verarbeitung und Veredelung der Folien als störend bis hin zu nicht akzeptabel darstellen kann. Innerhalb einer teilkristallin extrudierten Polyarylenetherketonfolie können die Schrumpfwerte durchaus von Null bis zu mehreren Prozent schwanken, je nachdem wo Proben zur Schrumpfmessung aus der Folienbahn entnommen werden. Gerade bei der Weiterverarbeitung bzw. Anwendung in höheren Temperaturbereichen ist es aber wichtig, dass die Folien eine möglichst hohe Formstabilität aufweisen.

Die Folie, die Gegenstand der vorliegenden Erfindung ist, wird mit einer Metallfolie laminiert. Hierbei muss gewährleistet sein, dass bei Temperaturänderungen während des Herstellungsprozesses oder im Laufe der Serieneinsatzbelastung die erforderliche Planlage des Laminats erhalten bleibt. Bei gleichzeitig stark unterschiedlichen thermischen Ausdehnungskoeffizienten der beiden Laminatpartner entstehen stark unterschiedliche Spannungen, die zum Einrollen des Laminats führen und gleichzeitig auch wieder die Haftung in der Grenzfläche stark beeinflussen können. Dies ist vor allem dann nachteilig, wenn das System in nachfolgenden Weiterverarbeitungsprozessen (beispielsweise bei Lötverfahren) hohen Temperaturschwankungen unterliegt. Das Laminat darf also z. B. nicht einrollen oder sich wellen. Hierzu müssen die Flächenausdehnungskoeffizienten der aufeinander fixierten dünnen Polyarylenetherketon- und Metallfolien nahezu identisch sein.

In der EP 1 314 760 A1 wird eine Folie zur Verwendung in gedruckten Schaltkreisen beschrieben, die aus einer Polyarylenetherketon-Formmasse bestehen kann. Die Formmasse enthält 15 bis 50 Gew.-% eines blättchenförmigen Füllstoffs, der beispielsweise Bornitrid sein kann. Durch diesen Zusatz werden der Schrumpf bei der Herstellung sowie die thermische Ausdehnung verringert, so dass die Folie sich für die Herstellung eines kleberlosen Laminats mit einer Kupferfolie eignen soll.

Die EP 1 234 857 A1 offenbart eine Formmasse für die Herstellung von Folien für FCBs auf Basis z. B. von Polyetheretherketon (PEEK), bei der durch einen Zusatz eines blättchenförmigen Füllstoffs mit bestimmten Parametern (vorzugsweise Glimmer; genannt ist auch Talkum) der Schrumpf sowie die thermische Ausdehnung verringert sind. Entsprechende Offenbarungen bezogen auf Talkum bzw. saures Magnesiummetasilikat finden sich in der JP 2007-197715A, der JP 2003-128943A sowie der JP 2003-128944A. Die EP 1 234 857 A1 spricht auch die Herstellung eines kleberlosen Laminats mit einer Kupferfolie an.

Die JP 2003-128931A schließlich beschreibt eine Formmasse zur Herstellung von Folien für FCBs auf Basis einer Vielzahl von Polymeren, beispielsweise Polyarylenetherketon. Die Formmasse ist mit 5 bis 50 Gew.-% an saurem Magnesiummetasilikat gefüllt. Darüber hinaus kann eine Reihe weiterer Füllstoffe enthalten sein, wobei Bornitrid als eine Möglichkeit genannt ist. Die Kombination Polyarylenetherketon/saures Magnesiummetasilikat/Bornitrid ist jedoch nicht explizit offenbart. Auch hier wird die Herstellung eines kleberlosen Laminats mit einer Kupferfolie angesprochen.

WO 2011/048093 A1 betrifft eine PAEK-enthaltende Formmasse (Art.54(3) EPÜ).

Die Aufgabe der Erfindung besteht darin, ein Verfahren zur Verfügung zu stellen, das ausgehend von einer Folie aus einer Polyarylenetherketon-Formmasse, die gegenüber dem Stand der Technik einen geringeren Schrumpf sowie einen verringerten thermischen Flächenausdehnungskoeffizienten aufweist, durch kleberloses Laminieren mit einer Metallfolie einen Verbund mit guter Haftung und mit guter Planlage ergibt.

Diese Aufgabe wird durch ein Verfahren gelöst, das folgende Schritte enthält:

I. Bereitstellen einer Folie mit einer Dicke von 5 bis 1200 µm, vorzugsweise 8 bis 600 µm und besonders bevorzugt 10 bis 400 µm aus einer Formmasse, die folgende Komponenten umfasst:

a) 60 bis 96 Gew.-Teile, bevorzugt 65 bis 94 Gew.-Teile, besonders bevorzugt 70 bis 92 Gew.-Teile und insbesondere bevorzugt 75 bis 90 Gew.-Teile Polyarylenetherketon,
b) 2 bis 25 Gew.-Teile, bevorzugt 4 bis 22 Gew.-Teile, besonders bevorzugt 6 bis 19 Gew.-Teile und insbesondere bevorzugt 8 bis 16 Gew.-Teile hexagonales Bornitrid sowie
c) 2 bis 25 Gew.-Teile, bevorzugt 4 bis 22 Gew.-Teile, besonders bevorzugt 6 bis 19 Gew.-Teile und insbesondere bevorzugt 8 bis 16 Gew.-Teile Talkum, wobei die Summe der Gewichtsteile der Komponenten a), b) und c) 100 beträgt;

II. Bereitstellen einer Metallfolie mit einer Dicke von 10 bis 150 µm und vorzugsweise 17 bis 105 µm;

III. Verpressen der unter I. und II. bereitgestellten Folien ohne Verwendung eines Klebers bei einer Temperatur im Bereich von $T_m$ - 40K bis $T_m$ + 40K, vorzugsweise bei einer Temperatur von $T_m$ - 20K bis $T_m$ + 30K, besonders bevorzugt bei einer Temperatur von $T_m$ - 10K bis $T_m$ + 25K und insbesondere bevorzugt bei einer Temperatur von $T_m$ - 5K bis $T_m$ + 20K, wobei $T_m$ der Kristallitschmelzpunkt des Polyarylenetherketons in der unter I. bereitgestellten Formmasse ist und $T_m$ an der Formmasse gemäß ISO 11357 beim 2. Aufheizen und einer Aufheiz- und Abkühlgeschwindigkeit von 20K/min bestimmt wird, und bei einem Druck von mindestens 4 bar ($4 \, . \, 10^5$ Pa) und maximal 5000 bar ($5.10^8$ Pa).

Bevorzugt wird ein Druck von mindestens 6 bar, mindestens 8 bar, mindestens 10 bar, mindestens 12 bar oder mindestens 15 bar und maximal 4000 bar, maximal 3000 bar, maximal 2000 bar, maximal 1500 bar, maximal 1000 bar oder maximal 800 bar angewandt, wobei jeder genannte Mindestwert mit jedem genannten Maximalwert kombiniert werden kann.
Die unter I. und II. bereitgestellten Folien können in Einzelnutzen, gegebenenfalls zusammen mit Trenn- und Ausgleichsfolien, aufeinander gestapelt und in einer Laminierpresse unter Vakuum mit Druck zu einem einseitig oder zweiseitig metallbeschichteten Laminat verpresst werden. Alternativ hierzu kann von Rolle zu Rolle zu Laminat-Meterware über eine geeignete Presse verpresst werden.
Das Polyarylenetherketon (PAEK) enthält Einheiten der Formeln

$$(\text{-Ar-X-}) \text{ und } (\text{-Ar'-Y-}),$$

wobei Ar und Ar' einen zweiwertigen aromatischen Rest darstellen, vorzugsweise 1,4-Phenylen, 4,4'-Biphenylen sowie 1,4-, 1,5- oder 2,6-Naphthylen. X ist eine elektronenziehende Gruppe, bevorzugt Carbonyl oder Sulfonyl, während Y eine andere Gruppe wie O, S, $CH_2$, Isopropyliden oder dergleichen darstellt. Hierbei sollten mindestens 50 %, bevorzugt mindestens 70 % und besonders bevorzugt mindestens 80 % der Gruppen X eine Carbonylgruppe darstellen, während mindestens 50 %, bevorzugt mindestens 70 % und besonders bevorzugt mindestens 80 % der Gruppen Y aus Sauerstoff bestehen sollten.
In der insbesondere bevorzugten Ausführungsform bestehen 100 % der Gruppen X aus Carbonylgruppen und 100 % der Gruppen Y aus Sauerstoff. In dieser Ausführungsform kann das PAEK beispielsweise ein Polyetheretherketon (PEEK; Formel I), ein Polyetherketon (PEK; Formel II), ein Polyetherketonketon (PEKK; Formel III) oder ein Polyetheretherketonketon (PEEKK; Formel IV) sein, jedoch sind natürlich auch andere Anordnungen der Carbonyl- und Sauerstoffgruppen möglich.

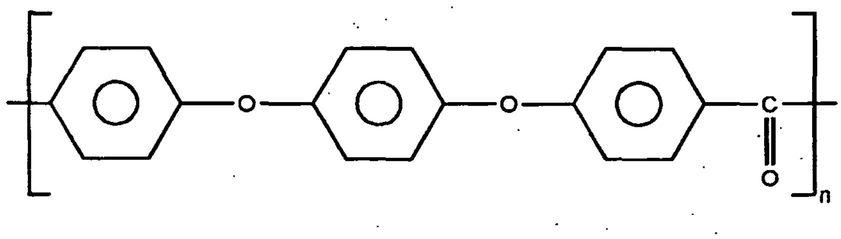

I

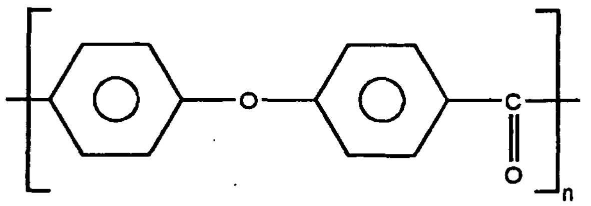

II

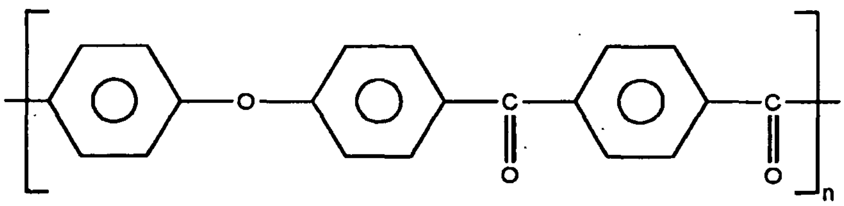

III

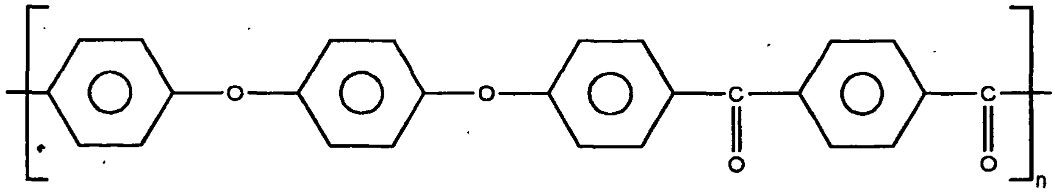

IV

Das PAEK ist teilkristallin, was sich beispielsweise in der DSC-Analyse durch Auffinden eines Kristallitschmelzpunkts $T_m$ äußert, der größenordnungsmäßig in den meisten Fällen um 300 °C oder darüber liegt. Im Allgemeinen gilt, dass Sulfonylgruppen, Biphenylengruppen, Naphthylengruppen oder sperrige Gruppen Y, wie z. B. eine Isopropylidengruppe, die Kristallinität verringern.

In einer bevorzugten Ausführungsform beträgt die Viskositätszahl, gemessen entsprechend DIN EN ISO 307 an einer Lösung von 250 mg PAEK in 50 ml 96-gewichtsprozentiger $H_2SO_4$ bei 25 °C, etwa 20 bis 150 $cm^3/g$ und bevorzugt 50 bis 120 $cm^3/g$.

Das PAEK kann gemäß der sogenannten nucleophilen Route durch Polykondensation von Bisphenolen und organischen Dihalogenverbindungen und/oder von Halogenphenolen in einem geeigneten Lösemittel in Gegenwart einer Hilfsbase hergestellt werden; das Verfahren ist beispielsweise in der EP-A-0 001 879, der EP-A-0 182 648 und der EP-A-0 244 167 beschrieben.

Das PAEK kann aber auch nach der sogenannten elektrophilen Route in stark saurem bzw. Lewis-saurem Milieu hergestellt werden; dieses Verfahren ist beispielsweise in der EP-A-1 170 318 sowie in der dort zitierten Literatur beschrieben.

Hexagonales Bornitrid besteht aus Schichten einer planaren, hexagonalen Wabenstruktur, bei der die B- und N-Atome jeweils abwechselnd vorkommen. Es ist somit dem Graphit vergleichbar; die physikalischen Eigenschaften von hexagonalem Bornitrid und Graphit sind sich sehr ähnlich. Im Unterschied zu Graphit leitet jedoch hexagonales Bornitrid erst bei sehr hohen Temperaturen den elektrischen Strom. Hexagonales Bornitrid ist in Form verschiedener Typen kommerziell erhältlich.

In einer bevorzugten Ausführungsform beträgt die Partikelgröße des hexagonalen Bornitrids bei $d_{50}$ mindestens 0,1 $\mu$m, mindestens 0,2 $\mu$m, mindestens 0,3 $\mu$m oder mindestens 0,4 $\mu$m sowie maximal 10 $\mu$m, maximal 8 $\mu$m, maximal 6 $\mu$m, maximal 5 $\mu$m, maximal 4 $\mu$m, maximal 3 $\mu$m oder maximal 2 $\mu$m. Entsprechend beträgt die Partikelgröße bei $d_{98}$ mindestens 0,3 $\mu$m, mindestens 0,6 $\mu$m, mindestens 0,7 $\mu$m oder mindestens 0,8 $\mu$m sowie maximal 20 $\mu$m, maximal 16 $\mu$m, maximal 12 $\mu$m, maximal 10 $\mu$m, maximal 8 $\mu$m, maximal 6 $\mu$m oder maximal 4 $\mu$m. Sowohl bei $d_{50}$ als auch bei $d_{98}$ können alle Ober- und Untergrenzen miteinander kombiniert werden.

Die Partikelgröße wird hier mittels Laserbeugung gemäß ISO 13320 gemessen, beispielsweise mit einem Mastersizer 2000 der Firma Malvern Instruments GmbH. Talkum ist ein natürlich vorkommendes Mineral der allgemeinen chemischen Zusammensetzung $Mg_3Si_4O_{10}(OH)_2$. Es ist ein kristallines Magnesiumsilikathydrat, das zur Familie der Schichtsilikate gehört. Talkum ist näher beschrieben beispielsweise in Kirk-Othmer, Encyclopedia of Chemical Technology, 4th Edition, Vol. 23, John Wiley & Sons 1997, Seiten 607 bis 616.

In einer bevorzugten Ausführungsform beträgt die Partikelgröße des Talkums bei $d_{50}$ mindestens 0,1 μm, mindestens 0,2 μm, mindestens 0,3 μm oder mindestens 0,4 μm sowie maximal 10 μm, maximal 8 μm, maximal 6 μm, maximal 5 μm, maximal 4 μm, maximal 3 μm oder maximal 2 μm. Entsprechend beträgt die Partikelgröße bei $d_{98}$ mindestens 0,3 μm, mindestens 0,6 μm, mindestens 0,7 μm oder mindestens 0,8 μm sowie maximal 20 μm, maximal 16 μm, maximal 12 μm, maximal 10 μm, maximal 8 μm, maximal 6 μm oder maximal 4 μm. Sowohl bei $d_{50}$ als auch bei $d_{98}$ können alle Ober- und Untergrenzen miteinander kombiniert werden.

Die Partikelgröße wird hier gemäß ISO 13317, Part 3 (X-ray Gravitational Technique) gemessen, beispielsweise mit einem Sedigraph 5120 der Firma Micromeritics Instrument Corporation.

Die Polyarylenetherketon-Formmasse kann darüber hinaus, falls erforderlich, auch weitere Komponenten enthalten wie beispielsweise Verarbeitungshilfsmittel, Stabilisatoren oder Flammschutzmittel. Art und Menge sind so zu wählen, dass der erfinderische Effekt nicht wesentlich beeinträchtigt wird. Zur besseren Anbindung der Füllstoffe und zur Verbesserung der Einreißfestigkeit können darüber hinaus zusätzlich Silane und/oder oligomere Siloxane zugegeben werden, beispielsweise in Anteilen von 0,5 bis 2,5 Gew.-% und vorzugsweise von 1 bis 2 Gew.-%, bezogen auf die Gesamtrezeptur.

Die Folie aus der Polyarylenetherketon-Formmasse kann nach folgendem Verfahren hergestellt werden:

a) In einem Compoundierschritt wird Polyarylenetherketon mit hexagonalem Bornitrid und Talkum in den anspruchsgemäßen Anteilen in der Schmelze gemischt;

b) in einem Extrusionsschritt wird die Schmelze der anspruchsgemäßen Formmasse in einem Breitschlitzwerkzeug extrudiert;

c) in einem Verfestigungsschritt wird die durch Extrusion ausgeformte Folienbahn abgezogen, auf Kühlwalzen aufgelegt und abgekühlt.

Im Compoundierschritt kann die Schmelze ausgetragen, abgekühlt und granuliert werden. Das Granulat wird dann im Extrusionsschritt im Extruder unter Scherung wieder aufgeschmolzen. Man kann jedoch auch einstufig arbeiten, indem sich der Extrusionsschritt in der gleichen Maschine direkt an den Compoundierschritt anschließt. Auf diese Weise wird das Granulieren vermieden, was kostengünstiger ist; darüber hinaus kann hier eine bessere Folienqualität erzielt werden.

Im Verlauf des Compoundier- oder Extrusionsschrittes kann die Schmelze der Formmasse, falls erforderlich, filtriert werden, um Stippen zu entfernen.

In einem anschließenden Konfektionierungsschritt kann in einer Wicklereinheit der Randbeschnitt und die Aufwicklung durchgeführt werden.

Falls für den gewählten Anwendungszweck die Haftung nicht ausreichen sollte, kann die Folie aus der Polyarylenetherketon-Formmasse auch einer Oberflächenbehandlung unterzogen werden, beispielsweise einer Coronabehandlung oder einer Plasmabehandlung.

Das Metall ist üblicherweise Kupfer, es kann aber auch Aluminium oder ein anderes Metall sein.

Überraschenderweise wurde festgestellt, dass bei gleichzeitiger Verwendung von hexagonalem Bornitrid und Talkum als Füllstoff eine synergistische Wirkung eintritt. Um den gewünschten Effekt zu erzielen, muss daher insgesamt eine geringere Menge an Füllstoff zugesetzt werden. Deshalb können erfindungsgemäß einsetzbare Folien mit verbesserten mechanischen Eigenschaften hergestellt werden, beispielsweise mit verbesserter Einreißfestigkeit und Weiterreißfestigkeit.

Der erfindungsgemäß hergestellte Folienverbund wird beispielsweise für Leiterplatten und hier insbesondere für flexible Leiterplatten verwendet. Bei letzterer Anwendung beträgt die Dicke der PAEK-Folienschicht vorzugsweise 6 bis 150 μm, besonders bevorzugt 12 bis 125 μm, insbesondere bevorzugt 18 bis 100 μm und ganz besonders bevorzugt 25 bis 75 μm.

Bei der Herstellung von flexiblen Leiterplatten wird das Leiterbild auf die Metallschicht gedruckt bzw. durch photolithographische Verfahren aufgebracht. Anschließend wird im Ätz- und Strippverfahren das Leiterbild erzeugt. Nun kann je nach Applikation sehr unterschiedlich verfahren werden. Weitere Prozessschritte sind beispielsweise Bohren, Stanzen, Oberflächenveredelung, Durchkontaktierung mittels Galvanisieren, Multilayer in Vakuumpressen erzeugen, Deckfolien unter Druck und Temperatur laminieren, Isolations- bzw. Lötstopplack drucken, verschiedene Lötprozesse (z. B. Lotpastendruck oder Bestückung mit Bauteilen) sowie Kontaktteilbestückung durch Crimpen, Piercen oder andere mechanische Verfahren. Die entsprechende Herstellung von flexiblen Leiterplatten ist Stand der Technik.

Mit den erfindungsgemäß eingesetzten Folien kann eine isotrope Folienformstabilität, d. h. sowohl in Längsals auch in Querrichtung, von weniger als 0,1 % Dimensionsänderung bei Temperaturen bis 260 °C erreicht werden. Um die Verhältnisse bei der Herstellung eines FCB zu simulieren, wird hierbei an einer 20 x 20 cm großen Folienprobe gemessen und zwar vor und nach einer 5 Minuten dauernden Temperaturbelastung von 260 °C. Dazu wird über 2 Längen und 2 Breiten, an insgesamt 8 Messpunkten, der Schrumpf der flächig ausgebreiteten Folienprobe bestimmt.

Damit soll die maximale Temperaturbelastung der Folie unter sogenannten Lötbadbedingungen nachgebildet werden, wobei der Belastungszeitraum großzügig lang bemessen wurde. Er beträgt hier mehr als das Fünffache der in gängigen Lötprozessen auftretenden Lötzeiten bei einer maximalen Temperaturbelastung von 260 °C. Dadurch wird sichergestellt, dass die Folie nicht in ihren Grenzbereich der Belastbarkeit gerät und die maximalen 0,1 % Schrumpf nach Lötung in longitudinaler und transversaler Richtung auf keinen Fall überschritten werden.

Die Erfindung wird im Folgenden beispielhaft erläutert.

Compoundieren:

Das Mischen und Granulieren der Materialien PEEK, Bornitrid (BN) und Talk erfolgte auf einer Anlage der Fa. Coperion (ZSK 26) mit einer gleichläufigen Doppelschnecke. Die Füllstoffe wurden über den ersten Einzug zugegeben; die Zugabe kann aber auch über Sidefeeder erfolgen. Die Verarbeitungstemperatur lag bei etwa 370 °C, der Durchsatz bei 8 bis 10 kg/h.

Folienherstellung:

Im Anschluss erfolgte die Herstellung von 50 μm dicken und 360 mm breiten Folien auf einer Folienextrusionsanlage der Fa. Dr. Collin mit einer Dreizonenschnecke mit folgenden Prozessparametern: Verarbeitungstemperatur etwa 370 °C, Durchsatz ca. 2 bis 3 kg/h, Abzugsgeschwindigkeit 5 m/min, Walzentemperaturen: 180 bis 250 °C.

Verbundherstellung:

Die Folie wurde zusammen mit einer elektrolytisch hergestellten Kupferfolie (Dicke 50 μm; Breite 360 mm) von Rolle zu Rolle zu Laminat verarbeitet. Die maximale Prozesstemperatur beim Laminieren betrug 335 °C; verpresst wurde unter einem Druck von 40 bar. Es wurde mit einer Abzugsgeschwindigkeit von 2 m/min gearbeitet. Aus dem Laminat wurden Streifen gestanzt, an denen mittels eines Peeltests die Haftung gemessen wurde. Zusätzlich wurde an 300 mm langen Laminatabschnitten die Biegeneigung bestimmt, wobei die Kupferseite sich beim Auflegen des Laminats auf eine ebene Fläche oben befand. Die Ergebnisse sind in der Tabelle 1 wiedergegeben.

Tabelle 1: Versuche

| Beispiel | Zusammensetzung PEEK-Folie [Gew.-Tle.] | $T_m$ | Bemerkung | Haftung längs gestanzt (Mitte) [N/mm] | Biegeneigung des Laminats (mm) |
|---|---|---|---|---|---|
| 1 | 70 PEEK<br>15 Bornitrid<br>15 Talkum | 339 °C | Cu glatte Seite | 1,7 | 0 (plan) |
| 2 | 70 PEEK<br>15 Bornitrid<br>15 Talkum | 339 °C | Cu rauhe Seite | 1,8 | 0 (plan) |
| 3[a] | 100 PEEK<br>0 Bornitrid<br>0 Talkum | 336 °C | Cu rauhe Seite | 0,04 | wegen fehlender Haftung nicht bestimmbar; zum Vergleich an geklebtem Laminat: 50 |
| [a] nicht erfingdungsgemäß | | | | | |

## Patentansprüche

1. Verfahren zur Herstellung eines Verbundes aus einer Folie aus einer Polyarylenetherketon-Formmasse und einer Metallfolie, das folgende Schritte enthält:

    I. Bereitstellen einer Folie mit einer Dicke von 5 bis 1200 μm aus einer Formmasse, die folgende Komponenten umfasst:

        a) 60 bis 96 Gew.-Teile Polyarylenetherketon,

b) 2 bis 25 Gew.-Teile hexagonales Bornitrid und
c) 2 bis 25 Gew.-Teile Talkum,
wobei die Summe der Gewichtsteile der Komponenten a), b) und c) 100 beträgt;

II. Bereitstellen einer Metallfolie mit einer Dicke von 10 bis 150 μm;
III. Verpressen der unter I. und II. bereitgestellten Folien ohne Verwendung eines Klebers bei einer Temperatur im Bereich von $T_m$ - 40K bis $T_m$ + 40K und bei einem Druck im Bereich von 4 bis 5000 bar, wobei $T_m$ der Kristallitschmelzpunkt des Polyarylenetherketons in der unter I. bereitgestellten Formmasse ist und $T_m$ an der Formmasse gemäß ISO 11357 beim 2. Aufheizen und einer Aufheiz- und Abkühlgeschwindigkeit von 20K/min bestimmt wird.

**2.** Verfahren gemäß Anspruch 1,
**dadurch gekennzeichnet,**
**dass** die unter I. bereitgestellte Folie eine Dicke von 8 bis 600 μm besitzt.

**3.** Verfahren gemäß einem der vorhergehenden Ansprüche,
**dadurch gekennzeichnet,**
**dass** die unter II. bereitgestellte Metallfolie eine Dicke von 17 bis 105 μm besitzt.

**4.** Verfahren gemäß einem der vorhergehenden Ansprüche,
**dadurch gekennzeichnet,**
**dass** das Polyarylenetherketon in der unter I. bereitgestellten Folie ein Polyetheretherketon (PEEK), ein Polyetherketon (PEK), ein Polyetherketonketon (PEKK) oder ein Polyetheretherketonketon (PEEKK) ist.

**5.** Verfahren gemäß einem der vorhergehenden Ansprüche,
**dadurch gekennzeichnet,**
**dass** die Partikelgröße des Bornitrids in der unter I. bereitgestellten Folie gemäß ISO 13320 bei $d_{50}$ mindestens 0,1 μm und maximal 10 μm und bei $d_{98}$ mindestens 0,3 μm und maximal 20 μm beträgt.

**6.** Verfahren gemäß einem der vorhergehenden Ansprüche,
**dadurch gekennzeichnet,**
**dass** die Partikelgröße des Talkums in der unter I. bereitgestellten Folie gemäß ISO 13317, Part 3 bei $d_{50}$ mindestens 0,1 μm und maximal 10 μm und bei $d_{98}$ mindestens 0,3 μm und maximal 20 μm beträgt.

**7.** Verfahren gemäß einem der vorhergehenden Ansprüche,
**dadurch gekennzeichnet,**
**dass** die Formmasse der unter I. bereitgestellten Folie zusätzlich Silane und/oder oligomere Siloxane enthält.

**8.** Verfahren gemäß einem der vorhergehenden Ansprüche,
**dadurch gekennzeichnet,**
**dass** die unter I. bereitgestellte Folie einseitig oder zweiseitig mit der unter II. bereitgestellten Metallfolie verpresst wird.

**9.** Verfahren gemäß einem der vorhergehenden Ansprüche,
**dadurch gekennzeichnet,**
**dass** die unter II. bereitgestellte Metallfolie aus Kupfer oder Aluminium besteht.

## Claims

**1.** Process which comprises the following steps for producing a composite made of a foil made of a polyarylene ether ketone moulding composition and a metal foil:

I.providing a foil of thickness from 5 to 1200 μm
made of a moulding composition which comprises the following components:

a) from 60 to 96 parts by weight of polyarylene ether ketone,
b) from 2 to 25 parts by weight of hexagonal boron nitride and

c) from 2 to 25 parts by weight of talc,

where the sum of the parts by weight of components a), b) and c) is 100;
II. providing a metal foil of thickness from 10 to 150 μm;
III. pressing the foils provided in I. and II.
without using an adhesive at a temperature in the range from $T_m$ - 40K to $T_m$ + 40K and at a pressure in the range from 4 to 5000 bar, where $T_m$ is the crystallite melting point of the polyarylene ether ketone in the moulding composition provided in I. and $T_m$ is determined on the moulding composition to ISO 11357 in the 2nd heating procedure and with a heating and cooling rate of 20K/min.

**2.** Process according to Claim 1,
**characterized in that**
the thickness of the foil provided in I. is from 8 to 600 μm.

**3.** Process according to any of the preceding claims, **characterized in that**
the thickness of the metal foil provided in II. is from 17 to 105 μm.

**4.** Process according to any of the preceding claims, **characterized in that**
the polyarylene ether ketone in the foil provided in I. is a polyether ether ketone (PEEK), a polyether ketone (PEK), a polyether ketone ketone (PEKK) or a polyether ether ketone ketone (PEEKK).

**5.** Process according to any of the preceding claims, **characterized in that**
the $d_{50}$ particle size of the boron nitride in the foil provided in I. to ISO 13320 is at least 0.1 μm and at most 10 μm and the corresponding $d_{98}$ is at least 0.3 μm and at most 20 μm.

**6.** Process according to any of the preceding claims, **characterized in that**
the $d_{50}$ particle size of the talc in the foil provided in I. to ISO 13317, Part 3 is at least 0.1 μm and at most 10 μm, and the corresponding $d_{98}$ is at least 0.3 μm and at most 20 μm.

**7.** Process according to any of the preceding claims, **characterized in that**
the moulding composition of the foil provided in I. also comprises silanes and/or oligomeric siloxanes.

**8.** Process according to any of the preceding claims, **characterized in that**
the foil provided in I. has been pressed on one or both sides with the metal foil provided in II.

**9.** Process according to any of the preceding claims, **characterized in that**
the metal foil provided in II. is composed of copper or aluminium.

## Revendications

**1.** Procédé pour la production d'un composite constitué d'une feuille à base d'une matière à mouler polyarylène-éthercétone et d'une feuille métallique, qui comporte les étapes suivantes :

I. disposition d'une feuille ayant une épaisseur de 5 à 1 200 μm à base d'une matière à mouler qui comprend les composants suivants :

a) 60 à 96 parties en poids de polyarylène-éthercétone,
b) 2 à 25 % en poids de nitrure de bore hexagonal et
c) 2 à 25 % en poids de talc,
la somme des parties en poids des composants a), b) et c) étant égale à 100 ;

II. disposition d'une feuille métallique ayant une épaisseur de 10 à 150 μm ;
III. pressage des feuilles disposées en I. et II. sans utilisation d'une colle, à une température dans la plage de $T_m$ - 40 K à $T_m$ + 40 K et sous une pression dans la plage de 4 à 5 000 bars, $T_m$ étant le point de fusion des cristallites de la polyarylène-éthercétone dans la matière à mouler disposée en I et $T_m$ étant déterminé sur la matière mouler selon ISO 11357 lors du 2$^e$ chauffage et à une vitesse de chauffage et de refroidissement de 20 K/min.

**2.** Procédé selon la revendication 1,
**caractérisé en ce que**
la feuille disposée en I. présente une épaisseur de 8 à 600 μm.

**3.** Procédé selon l'une quelconque des revendications précédentes,
**caractérisé en ce que**
la feuille métallique disposée en II. présente une épaisseur de 17 à 105 μm.

**4.** Procédé selon l'une quelconque des revendications précédentes,
**caractérisé en ce que**
la polyarylène-éthercétone dans la feuille disposée en I. est une polyétheréthercétone (PEEK), une polyéthercétone (PEK), une polyéthercétone-cétone (PEKK) ou une polyétheréthercétone-cétone (PEEKK).

**5.** Procédé selon l'une quelconque des revendications précédentes,
**caractérisé en ce que**
la taille de particule du nitrure de bore dans la feuille disposée en I. est selon ISO 13320 pour $d_{50}$ d'au moins 0,1 μm et d'au maximum 10 μm et pour $d_{98}$ d'au moins 0,3 μm et d'au maximum 20 μm.

**6.** Procédé selon l'une quelconque des revendications précédentes,
**caractérisé en ce que**
la taille de particule du talc dans la feuille disposée en I. est selon ISO 13317, partie 3, pour $d_{50}$ d'au moins 0,1 μm et d'au maximum 10 μm et pour $d_{98}$ d'au moins 0,3 μm et d'au maximum 20 μm.

**7.** Procédé selon l'une quelconque des revendications précédentes,
**caractérisé en ce que**
la matière à mouler de la feuille disposée en I. contient en outre des silanes et/ou des siloxanes oligomères.

**8.** Procédé selon l'une quelconque des revendications précédentes,
**caractérisé en ce que**
la feuille disposée en I. est pressée d'un côté ou des deux avec la feuille métallique disposée en II.

**9.** Procédé selon l'une quelconque des revendications précédentes,
**caractérisé en ce que**
la feuille métallique disposée en II. consiste en cuivre ou aluminium.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 1314760 A1
- EP 1234857 A1
- JP 2007197715 A
- JP 2003128943 A
- JP 2003128944 A
- JP 2003128931 A
- WO 2011048093 A1
- EP 0001879 A
- EP 0182648 A
- EP 0244167 A
- EP 1170318 A


### In der Beschreibung aufgeführte Nicht-Patentliteratur


- **KIRK-OTHMER.** Encyclopedia of Chemical Technology. John Wiley & Sons, 1997, vol. 23, 607-616